# EUROPÄISCHE PATENTSCHRIFT

(11) **EP 0 413 853 B1**
(45) Veröffentlichungstag und Bekanntmachung des Hinweises auf die Patenterteilung: **31.01.1996**
(21) Anmeldenummer: 89121634.3
(22) Anmeldetag: 23.11.1989
(51) Int. Cl.: C23C 14/06, C23C 14/22, C23C 30/00

(54) **Beschichtetes Werkstück mit einer Mischkristallbeschichtung, Verfahren zu dessen Herstellung, sowie Vorrichtung zur Durchführung des Verfahrens**
Workpiece coated with a solid solution crystalline layer, process and apparatus for its manufacture
Pièce pourvue d'une couche cristalline mixte, procédé et dispositif pour sa production

(30) Priorität: 21.08.1989 CH 3037/89
(43) Veröffentlichungstag der Anmeldung: 27.02.1991
(73) Patentinhaber: BALZERS AKTIENGESELLSCHAFT, FL-9496 Balzers (LI)
(72) Erfinder: Schmid, Roland, Dr., A-6811 Göfis (AT)
(74) Vertreter: Keller, René, Dr.

(56) Entgegenhaltungen:
- EP-A- 0 093 706
- EP-A- 0 288 316
- EP-A- 0 302 984
- EP-A- 0 306 612
- WO-A-86/00649
- DD-A- 246 571
- US-A- 4 448 802

## Beschreibung

Die Erfindung betrifft ein beschichtetes Werkstück gemäss dem Oberbegriff des Patentanspruchs 1, ein Verfahren zu dessen Herstellung gemäss dem Oberbegriff des Patentanspruchs 12 und eine Vorrichtung zur Durchführung des Verfahrens gemäss dem Oberbegriff des Patentanspruchs 20. Bevorzugte Ausführungsformen der Erfindung sind in den entsprechenden abhängigen Ansprüchen 2 bis 11, 13-19 und 21 beausprucht.

Ein reaktives PVD-Beschichtungsverfahren dieser Art und ein Werkstück beschichtet nach dem Verfahren, um dessen Härte, sowie Zähigkeit zu erhöhen, sind aus der EP-A 0 191 554 bekannt; derartige Werkstücke werden z. B. als Schneidwerkzeuge verwendet. Die bekannte Beschichtung wird mittels eines PVD-Verfahrens bei Temperaturen zwischen 200 und 700 °C durchgeführt. Es werden bis zu vier diskrete Schichten aus Titankarbid, Titannitrid und Titankarbonitrid aufgebracht, wobei unmittelbar über der zu beschichtenden Oberfläche immer eine Titannitridschicht aufgebracht wird.

Aus der EP-A 0 306 612 ist ein weiteres gattungsgemäßes reaktives PVD-Beschichtungsverfahren bekannt. Es handelt sich hier um ein magnetfeldunterstütztes Kathodenzerstäubungsverfahren kombiniert mit einem elektrischen Bogenentladungsverfahren, mit dem kompakte, dichte Schichten auf Werkzeugen unter Vermeidung einer Stengel struktur in der Beschichtung erzeugt werden. Die zu beschichtenden Werkzeuge werden abwechselnd in rascher Folge einer Metall verdampfenden Bogenentladungselektrode und einer Zerstäubungsquelle ausgesetzt, wobei der Niederschlag von Metalldampf für die betreffenden Schichten zu mehr als 95 von 100 Teilen aus der magnetfeldunterstützten Kathodenzerstäubung herrührt. Die Zeitdauer für eine Kathodenzerstäubungsbeschichtung ist hierbei so kurz gewählt, daß sich jeweils während der Einzelperiode nicht mehr als eine 30 Nanometer dicke Teilschicht niederschlagen kann. Um eine gleichmäßige Beschichtung aller auf einem Drehteller angeordneter Werkzeuge zu erreichen, werden die Werkzeuge gleichzeitig in eine kontinuierliche oder intermittierende Drehung um ihre vertikale Achse versetzt. Die zu erreichende Homogenität der Beschichtung wird mit einem Rasterelektronen-Mikroskop überprüft.

Aus der EP-A 0 302 984 ist eine weitere nicht gattungsgemäße Hartmetallschneidwerkzeugbeschichtung bekannt. Es erfolgt hier gegenüber der oben erwähnten reaktiven PVD-Beschichtungsverfahren eine Beschichtung mit einem CVD-Verfahren (chemical vapor deposition). Im Gegensatz zur homogenen Materialverteilung in der Beschichtung der EP-A 0 306 612 wird hier eine Inselbildung von Ausscheidungen bzw. Einlagerungen aus Oxiden und/oder Nitriden und/oder Karbiden in den Schichten angestrebt, um eine gute Verschleißfestigkeit des beschichteten Werkzeugs zu erhalten.

Durch die Erfindung, wie sie in den Ansprüchen gekennzeichnet ist, wird die Aufgabe gelöst, ein beschichtetes Werkstück, sowie ein Verfahren zur Herstellung des beschichteten Werkstücks zu schaffen, bei dem die aufgebrachten Schichten auf der Werkstückoberfläche gut haften und eine hohe Zähigkeit aufweisen.

In den Patentansprüchen 2 bis 13 sind bevorzugte Ausführungsarten des erfindungsgemäß beschichteten Werkstücks und in den Patentansprüchen 15 bis 21 bevorzugte Ausführungsarten des erfindungsgemäßen Verfehrens beschrieben.

Im folgenden wird ein Beispiel des erfindungsgemäßen Verfahrens und des erfindungsgemäß beschichteten Werkstücks anhand von zeichnerischen Darstellungen näher erläutert. Es zeigen:
Fig. 1 eine schematische Darstellung einer Aufdampfanlage,
Fig. 2a - f den zeitlichen Verlauf verschiedener Größen während des Aufbringens von Schichten auf den Werkstücken, und
Fig. 3a - c prozentuale Anteile der aufgedampften Materialien über der Schichtdicke.

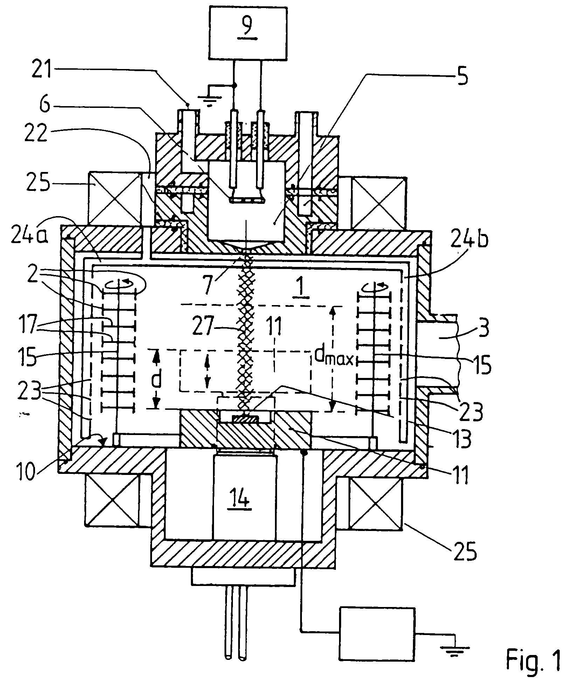

**Figur 1** zeigt ein Beispiel einer Aufdampfanlage zur Durchführung des erfindungsgemäßen Verfahrens zur Herstellung beschichteter Werkstücke **2**. Die Einrichtung hat eine Vakuumkammer **1** mit einem Evakuierungsanschluß **3** und eine Glühkathodenkammer **5** mit einer Glühkathode **6**, die über eine Öffnung **7** mit der Vakuumkammer **1** verbunden ist. Die Glühkathode **6** wird von einem Stromversorgungsgerät **9** gespeist. Annähernd über der Mitte des Bodens **10** der Vakuumkammer **1** befindet sich ein kühlbarer, in der Höhe verschiebbarer Tiegel **11**, in dem Titan **13** in den gasförmigen Zustand durch Verdampfen überführt wird. Gestrichelt ist in **Figur 1** der Tiegel **11** um eine Distanz d von dessen unterster Position entfernt eingezeichnet. Die Verstellung erfolgt über eine in der Höhe verstellbare Bewegungseinrichtung **14**; Sie besteht aus drei mit einer Spindelführung ineinanderschiebbaren Zylindern. In der Vakuumkammer **1** sind zwölf um die Längsachse drehbare Träger **15,** von denen zwei dargestellt sind, vorhanden, an denen die zu beschichtenden Werkstücke **2** an je einer Halterung **17** gehalten werden. Die Glühkathodenkammer **5** hat ferner einen Kühlmittelkanal **19**, um deren Wand während des Betriebs zu kühlen. In die Glühkathodenkammer **5** und in die Vakuumkammer **1** münden je eine Gaszuleitung **21** und **22**, wobei die Gaszuleitung **22** in der Vakuumkammer **1** in mehrere mit Öffnungen **23** versehene Zweige **24a**, **24b**, von denen zwei dargestellt sind, sich aufteilt, um eine möglichst gleichmäßige Verteilung des durch die Gaszuleitung **22** eingelassenen Gases bzw. Gasgemisches innerhalb der Vakuumkammer **1** zu erreichen. Zwei schematisch dargestellte Magnetspulen **25** befinden sich unterhalb des Bodens **10** und oberhalb eines Deckelteils **26** der Vakuumkammer **1** rotationssymmetrisch zum Tiegel **11** zur Erzeugung eines annähernd parallelen vertikalen Magnetfelds.

Zur Herstellung der beschichteten Werkstücke **2** werden diese an den Halterungen **17** der Träger **15** befestigt und Titan **13** in den Tiegel **11** gelegt. In einem ersten Verfahrensschritt wird die Vakuumkammer **1** geschlossen, evakuiert und über die Gaszuleitung **21** das Edelgas Argon bis zum Erreichen eines Partialdrucks von 200mPa eingelassen. Zum Aufheizen und Ionenätzen der Werkstückoberflächen brennt ein Niedervoltbogen in der Argonathmosphäre von der Glühkathode **6** zu dem Oberflächen der Werkstücke **2**. Zur gleichmäßigen Erwärmung und Reinigung der um den Träger 15 herum angeordneten Werkstücke 2, rotieren die Träger mit etwa einer Umdrehung in fünf Sekunden.

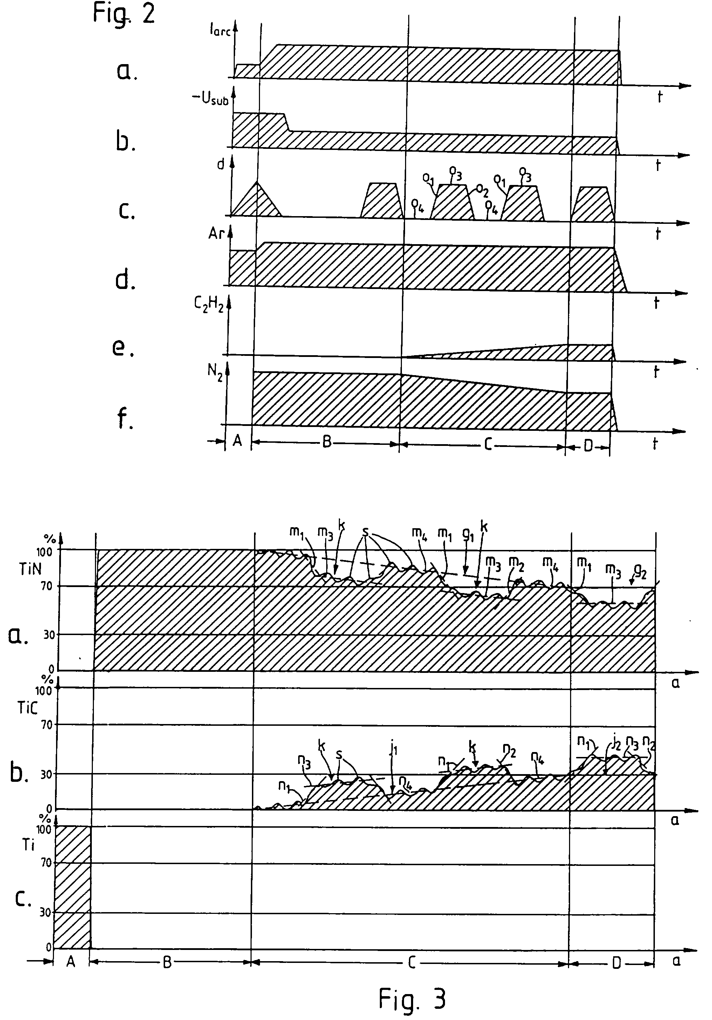

Der zeitliche Ablauf der einzelnen Verfahrensschritte zur Herstellung der Beschichtung nach der Reinigung und Erwärmung ist in **Figur 2** dargestellt. Die jeweils während eines der Verfahrensschritte erzeugten Schichten, nämlich eine Unterschicht **A**, eine Trennschicht **B**, eine erste Teilschicht **C** einer Mischkristallschicht und eine zweite Teilschicht **D** der Mischkristallschicht, welche die oberste Schicht der Beschichtung bildet, sind auf der Abszisse aufgetragen. **Figur 2a** zeigt den zeitlichen Stromverlauf **I**_{**arc**} der Stromstärke des Niedervoltbogens an, **Figur 2b** den Verlauf der negativen Vorspannung **U**_{**sub**} an den Werkstücken **2**, **Figur 2c** den Abstand **d** des Tiegels **11** von dessen unterster Position auf den Boden **10** der Vakuumkammer **1**, **Figur 2d** den Gasfluß des Argons **Ar** in die Vakuumkammer **1** durch die Gaszuleitung **21**, **Figur 2e** den Gasfluß des Acetylens **C₂H₂** durch den Gaseinlaß **22 und Figur 2f** den Gasfluß des Stickstoffs **N₂**.

Anschließend an die Erwärmung und Reinigung der Oberflächen der Werkstücke **2** wird in einem nächsten Verfahrensschritt eine Titanunterschicht **A** von annähernd 1000 Å direkt auf die Oberflächen der Werkstücke **2** aufgebracht.

Die während des gesamten Verfahrens auf der Oberfläche der Werkstücke **2** abgelagerten Materialien sind in **Figur 3** in ihrer prozentualen Zusammensetzung im Abstand **a** von der ursprünglichen Werkstückoberfläche aufgetragen. In **Figur 3a** ist der Titannitridgehalt **TiN**, in **Figur 3b** der Titankarbid **TiC** und in **Figur 3c** der Gehalt an reinem Titan **Ti** aufgetragen.

Zum Aufbringen der reinen Titanschicht **A**, siehe **Figur 3c** und **Figur 2**, brennt der Niedervoltbogen **27** von der Glühkathode **6** zum Tiegel **11** mit einem Strom **(Figur 2a)** von annähernd 80A; die Werkstücke **2** liegen gegenüber dem Tiegel **11** auf einem Potential **(Figur 2b)** von etwa -100V. Das verdampfende Titan **Ti** wird in der Gasentladung ionisiert und von den Oberflächen der Werkstücke **2** angezogen. Zur Erzielung einer gleichmäßigen Titanschicht wird der Tiegel **11** in Richtung zur Glühkathode **6** hin vom Boden **10** der Vakuumkammer **1** weg bis zu einem maximalen Abstand **d**_{**max**} an den an den Trägern **15** befestigten Werkstücken **2** vorbei bewegt (siehe **Figur 2c**). Die Zeit zur Herstellung dieser Titanunterschicht **A** ist so groß gewählt, daß die Oberflächen der sich drehenden Werkstücke **2** mehrere Male zum Tiegel **11** zeigen.

Ist die Titanunterschicht mit einer Dicke von annähernd 1000 Å aufgedampft, wird in einem nächsten Verfahrensschritt durch den Gaseinlaß **22** Stickstoff **N₂ (Figur 2f)** bei brennendem Niedervoltbogen **27** eingelassen, wobei ein Stickstoffpartialdruck von 50 mPa eingestellt wird, um ein ausreichendes Angebot an Stickstoffatomen und -ionen für eine vollständige Reaktion mit dem verdampften Titan **Ti** zur Verfügung zu haben, wobei die Verdampfung durch Erhöhung des Stroms **(Figur 2a)** des Niedervoltbogens **27** auf etwa 200 A gesteigert wird. Durch die Zweige **24a, 24b**, etc. verteilt sich der Stickstoff **N₂** gleichmäßig in der Vakuumkammer **1** und bildet mit dem Titandampf **Ti** Titannitrid **TiN**, welches sich auf den Oberflächen der Werkstücke **2** niederschlägt. Von den Werkstücken **2** fließt ein Strom von annähernd 20 A nach Erniedrigung der negativen Vorspannung **(Figur 2b)** auf -50V. Auch während dieses Verfahrensschritts rotieren die Werkstücke **2**. Der Tiegel **11 (Figur 2c)** wird von seiner obersten Position nach unten gegen den Boden **10** und gegen Ende dieses Vefahrensschritts noch einmal nach oben und wieder nach unten bewegt, um eine glelchmäßige Beschichtung mit Titannitrid **TiN** zu erhalten.

Nachdem eine Trennschicht **B** aus Titannitrid **TiN** mit einer Dicke von etwa einem Mikrometer (die Dicke kann je nach Verwendungszweck der Werkstücke **2** geändert werden) aufgedampft wurde, wird Acetylen **C₂H₂** als Kohlenstoff abgebendes Gas, wie in **Figur 2e** dargestellt, zusammen mit dem Stickstoff **N₂** in einem weiteren Verfahrensschritt durch den Gaseinlaß **22** eingelassen und über die Zweige **24a, 24b**, etc. gleichmäßig in der Vakuumkammer **1** verteilt. In dem Maße, wie der Anteil an Acetylen **C₂H₂** in der Vakuumkammer **1** steigt, wird der Stickstoffanteil **N₂** reduziert; siehe **Figuren 2e** und **2f**. Durch die Gasentladung wird das Acetylen **C₂H₂** aufgespalten und der abgespaltene Kohlenstoff ionisiert. Sowohl der ionisierte Kohlenstoff, wie auch der ionisierte Stickstoff verbinden sich mit dem Titandampf **Ti** zu Titannitrid **TiN** bzw. Titankarbid **TiC**. Der Acetylenzufluß wird derart gesteigert und der Stickstoffzufluß derart reduziert bis 70% Stickstoff **N₂** und 30% Acetylen **C₂H₂** in der Vakuumkammner **1** enthalten sind. Der Argonzufluß bleibt (siehe **Figur 2d**). Während der Erhöhung des Acetylenzuflusses wird der Tiegel **11** (siehe **Figur 2c**) zweimal hin und her bewegt. Während des Hin- und Herbewegen entsteht eine Mischkristallschicht, die Teilschicht **C**, mit einer Schichtdicke von etwa zwei Mikrometern aus Titankarbid **TiC** und Titannitrid **TiN**. Je nach Verwendungszweck der Werkstücke **2** beträgt die Schichtdicke bevorzugt 1,2 bis 2 mal die Schichtdicke der Trennschicht **B**.

Nachdem der Acetylenzufluß 30% des Stickstoffzuflusses erreicht hat, wird in einem weiteren Verfahrensschritt eine etwa ein Mikrometer dicke Teilschicht **D** (dünnere Teilschicht **D** der Mischkristallschicht) mit diesem konstanten Stickstoff-Acetylen-Verhältnis gebildet. Je nach Verwendungszweck der Werkstücke **2** liegt diese Schichtdicke zwischen einem Fünftel der vorhergehenden Schicht **C** und deren Hälfte.

Überraschenderweise verschwanden durch die oben geschilderte Rotation der Werkstücke **2**, sowie der Auf- und Abbewegung des Tiegels **11** weitgehend die die Haftfähigkeit und Zähigkeit beeinträchtigenden Kohlenstoffeinschlüsse in den aufgebrachten Schichten **C** und **D**. Auch konnte aufgrund angefertigter Dünnschliffe an beschichteten Werkstücken **2** festgestellt werden, daß einer stetigen Zunahme des Titankarbidgehalts der aufgebrachten Schicht **C** Konzentrationsschwankungen **k** von Titankarbid **TiC** zu Titannitrid **TiN**, welche mit den Bewegungen des Tiegels **11** übereinstimmen, überlagert waren. Diesen Schwankungen überlagerten sich weitere Konzentrationsschwankungen **s**, welche mit der Rotation der Träger **15** korrelieren.

In **Figur 3** ist der Konzentrationsverlauf von reinem Titan **Ti (Figur 3a)**, Titannitrid **TiN (Figur 3b)** und Titankarbid **TiC (Figur 3c)** entsprechend einem Dünnschliff dargestellt. Die Schwankungen mit kleiner Amplitude **s** und kleiner Periode im Dickenbereich **C** und **D** (siehe auch **Figur 2**) rühren von der Drehbewegung der Werkstücke **2** auf den Trägern **15** her. Die beiden Schwankungen mit großer Amplitude **k** und großer Periode im Bereich **C**, sowie die eine Schwankung im Bereich **D** sind auf die beiden Auf- und Abbewegungen des Tiegels **11** während der Bedampfung der Schicht im Bereich **C** und der einen Auf- und Abbewegung im Bereich **D** zurückzuführen.

Die gestrichelten Geraden **g₁** und **g₂** in **Figur 3a** bzw. **j₁** und **j₂** in **Figur 3b** -geben den prozentualen Titankarbid **TiC** bzw. Titannitridgehalt **TiN** der aufgedampften Schicht an, söfern keine Tiegelbewegungen und keine Werkstückbewegungen erfolgt wären. Der Verlauf der Geraden **m₁** bis **m₄** für das Titannitrid **TiN** und **n₁** bis **n₄** für das Titankarbid **TiC** gibt den Verlauf des prozentualen Titannitrid- **TiN** bzw. Titankarbidgehalts **TiC** einer aufgedampften Schicht an, wenn auf die Rotation der Werkstücke **2** um Träger **15** verzichtet worden wäre. Die verwendeten Indizes stimmen mit den Indizes der Bewegung **o** des Tiegels **11** in Figur **2c** überein. Die in **Figur 3** dargestellten Kurven gelten für Werkstücke **2** in der Nähe des Bodens **10**. Für Werkstücke **2** in der Nähe des Deckelteils **26** ist die Gerade **m₁** symmetrisch zur Geraden **g₁** noch oben und die Gerade **n₁** symmetrisch zur Geraden **j₁** nach unten geklappt. Analoges gilt für die Geraden **m₂** und **n₂**. Die Gerade **m₃** liegt dann oberhalb der Geraden **g₁** bzw. **g₂** und die Gerade **n₃** unterhalb der Geraden **j₁** bzw. **j₂**.

Wie bereits aus der EP-A-0 191 554 bekannt, sind Werkstücke, die nur mit Titannitrid **TiN** beschichtet sind, aufgrund ihrer geringeren Härte gegenüber Freiflächenverschleiß weniger widerstandsfähig als Werkstücke, die nur mit Titankarbid **TiC** beschichtet sind. Jedoch hat ein nur mit Titankarbid **TiC** beschichtetes Werkstück wegen der geringeren chemischen Widerstandsfähigkeit einen größeren Kolkverschleiß. In der EP-A-0 191 554 wurde versucht, beide Vorteile dadurch zu vereinen, daß auf eine Titannitridschicht **TiN** eine Titankarbid- **TiC** oder Titankarbonitridschicht **TiCN** aufgebracht wurde.

Es hat sich nun gezeigt, daß die Beschichtung hergestellt nach dem erfindungsgemäßen Verfahren, bei dem keine diskreten einzelnen Schichten mehr vorhanden sind, sondern nur noch Schichten, deren Einlagerungsverhältnis über der Schichtdicke kontinuierlich schwankt, eine bedeutend höhere Haftfähigkeit auf dem Werkstück aufweisen und die Werkstücke eine bedeutend höhere Zähigkeit besitzen, als diejenigen beschichtet nach dem bekannten Verfahren.

Bei Dauerversuchen konnten mit einem unbeschichteten Gewindebohrer M8 7 000 Gewinde geschnitten werden, mit einem mit TiN beschichteten Gewindebohrer wurden 25 000 und mit einem Gewindebohrer mit einer erfindungsgemäßen Beschichtung 75 000 Gewinde geschnitten. Bei einem Prägelochstempel Werkstoff 1.0334 ergaben sich bei unbeschichtetem Material 20 000, mit TiN beschichtetem 62 000 und mit dem erfindungsgemäß beschichtetem Material 140 000 Prägungen.

Die Konzentrationsschwankungen innerhalb der Beschichtung können mit großer Wahrscheinlichkeit auf die unterschiedliche Affinität von ionisierten Kohlenstoff und Stickstoff zu Titandampf erklärt werden. Solange nur Stickstoff vorhanden ist, verbindet sich dieser mit dem Titan. Ist ionisierten Kohlenstoff vorhanden, so verbindet sich dieser bevorzugt mit dem Titan, d. h. das Gebiet unmittelbar um dem Tiegel **11** verarmt an Kohlenstoff, da sich dieser mit dem Titan verbunden hat. Je geringer also der Abstand einer Werkstückoberfläche von Tiegel **11** ist desto mehr Titannitrid TiN schlägt sich auf dessen Oberfläche nieder.

Anstelle Acetylen C₂H₂ als Kohlenstoff abgebendes Gas zu verwenden, können Äthylen C₂H₄ oder andere Kohlenstoff abgebende Gase verwendet werden.

Anstelle der zwei Schwankungen in der ersten Teil schicht **C** der Mischkristallschicht können auch mehrere Schwankungen durch eine größere Anzahl von Tiegelbewegungen erzeugt werden; bevorzugt werden ein bis fünf Schwankungen pro zwei Mikrometer erzeugt. Auch kann die Rotationsbewegung der Werkstücke **2** um die Träger **15** im Bereich von 5 bis 100 Perioden pro Tiegelzyklus variiert werden.

Anstelle das Titan **13** im Tiegel **11** mit einem Niedervoltbogen in den gasförmigen Zustand zu überführen, kann auch eine Kathodenzerstäubung (Sputtern), eine plasmaunterstütze Verdampfung oder eine kathodische Bogenverdampfung erfolgen.

## Patentansprüche

1. Beschichtetes Werkstück (2) mit einer mit einem reaktiven physikalischen Beschichtungsverfahren aufgebrachten, gut haftenden, zähen Mischkristallbeschichtung (C, D) aus Titannitrid und Titankarbid, deren Konzentrationsverhältnis zueinander wenigstens in einem überwiegenden Mischkristallbeschichtungs-Teilbereich (C) in Richtung der Flächennormalen stetig mit einer periodischen Aenderungskomponente (k) zu- und abnimmt.

2. Beschichtetes Werkstück (2) nach Anspruch 1, dadurch gekennzeichnet, dass die Mischkristallbeschichtung (C, D) auf einem Trennschichtbereich (B) angeordnet ist, der nur Titannitrid oder Titankarbid enthält, dass der Konzentrationsverlauf bezüglich Titannitrid bzw. Titankarbid zwischen dem Trennschichtbereich (B) und der Mischkristallbeschichtung (C, D) stetig ist und dass die Mischkristallbeschichtung (C, D) bevorzugt 1,2 bis 2 mal so dick ist wie der Trennschichtbereich (B).

3. Beschichtetes Werkstück (2) nach Anspruch 2, dadurch gekennzeichnet, dass die Mischkristallbeschichtung (C, D) aus einem dem Werkstück (2) zugewandten ersten Mischkristallbeschichtungs-Teilbereich (C) mit sich stetig änderndem Konzentrationsverhältnis und einem dem Werkstück abgewandten, zweiten, dünneren Mischkristallbeschichtungs-Teilbereich (D) mit wenigstens annähernd konstantem Konzentrationsverhältnis besteht, wobei das Konzentrationsverhältnis des ersten Teilbereichs (C) stetig in dasjenige des zweiten Teilbereichs (D) übergeht, und der erste Teilbereich (C) 2 bis 5 mal so dick ist wie der zweite (D).

4. Beschichtetes Werkstück (2) nach einem der Ansprüche 1 bis 3, dadurch gekennzeichnet, dass der periodischen Aenderungskomponente (k) des Konzentrationsverhältnisses im ersten Mischkristallbeschichtungs-Teilbereich (C, D) eine zweite Aenderungskomponente (m,n) überlagert ist, welche in Richtung der Flächennormalen in der Art einer Geraden zu- oder abnimmt.

5. Beschichtetes Werkstück (2) nach einem der Ansprüche 1 bis 4, dadurch gekennzeichnet, dass das Konzentrationsverhältnis in Richtung der Flächennormalen periodisch schwankend mit bevorzugt 1 bis 5 Schwankungen pro etwa zwei Mikrometer Schichtdicke zu- oder abnimmt.

6. Beschichtetes Werkstück (2) nach einem der Ansprüche 1 bis 5, dadurch gekennzeichnet, dass der periodischen ersten Aenderungskomponente (k) des Konzentrationsverhältnisses eine periodische dritte Aenderungskomponente (s) des Konzentrationsverhältnisses mit kleinerer räumlicher Periode und kleinerer Konzentrationsverhältnisschwankung mit 5 bis 100 Schwankungen der dritten Aenderungskomponente (s) pro Schwankung der ersten Aenderungskomponente (k) überlagert ist.

7. Beschichtetes Werkstück (2) nach einem der Ansprüche 2 bis 6, dadurch gekennzeichnet, dass der Trennschichtbereich (B) auf einer bevorzugt 0,01 bis 0,5 µm dicken Unterschicht (A) liegt.

8. Beschichtetes Werkstück (2) nach einem der Ansprüche 1 bis 7, dadurch gekennzeichnet, dass der Trennschichtbereich (B) aus Titannitrid besteht.

9. Beschichtetes Werkstück (2) nach einem der Ansprüche 1 bis 8, dadurch gekennzeichnet, dass die Unterschicht (A) aus Titan besteht.

10. Beschichtetes Werkstück (2) nach einem der Ansprüche 3 bis 9, dadurch gekennzeichnet, dass der zweite Teilschichtbereich (D) aus einem Mischkristall mit annähernd 30% Titankarbid und 70% Titannitrid besteht.

11. Beschichtetes Werkstück (2) gemäss einem der Ansprüche 1 bis 10, dadurch gekennzeichnet, dass es als Schneid-oder Formwerkzeug ausgebildet ist.

12. Reaktives PVD-Beschichtungsverfahren zur Herstellung des beschichteten Werkstücks (2) nach einem der Ansprüche 1 bis 11, bei dem ein mittels einer Dampfquelle (11) in einer Vakuumkammer (1) in den gasförmigen Zustand überführtes Metall unter chemischer Reaktion mit einem in die Vakuumkammer (1) eingeleiteten gasförmigen Reaktionsmittel auf einer Oberfläche eines bewegten Werkstücks (2) niedergeschlagen wird, dadurch gekennzeichnet, dass als Reaktionsmittel ein erstes Gas mit einem stetig verringerten Zufluss und ein zweites Gas mit einem stetig erhöhten Zufluss zur Bildung einer ersten bzw. zweiten Verbindung eingeleitet werden, und das Werkstück (2) relativ so in bezug zur Dampfquelle (11) bewegt wird, dass sich dessen Abstand und/oder dessen Ausrichtung zur Dampfquelle (11) mit einer derartigen Geschwindigkeit periodisch ändert, dass auf dem Werkstück (2) eine Mischkristallbeschichtung mit den genannten Verbindungen abgeschieden wird, deren Konzentrationsverhältnis zueinander sich nur in Richtung der Flächennormalen aus einer Ueberlagerung der periodischen den Abstandsänderungen entsprechenden Konzentrations-änderungen und der der Zuflussänderung entsprechenden Konzentrationsänderung zusammensetzt.

13. Verfahren nach Anspruch 12, bei dem das Metall (13) mittels einer Bogenverdampfung, insbesondere einer Niedervoltbogenverdampfung, aus einer Dampfquelle (11 ) verdampft wird.

14. Verfahren nach Anspruch 12 oder 13, dadurch gekennzeichnet, dass die Dampfquelle (11) periodisch entlang der zu beschichtenden Oberfläche des Werkstücks derart bewegt wird, dass das Konzentrationsverhältnis der genannten Verbindungen des sich auf der Oberfläche bildenden Mischkristallbeschichtungs-Teilbereichs (C) sich längs der Bewegungsrichtung ändert.

15. Verfahren nach den Ansprüchen 12 und 14 oder 13 und 14, dadurch gekennzeichnet, dass die Dampfquelle (11) mit einer kleineren Geschwindigkeit als das Werkstück (2) bewegt wird.

16. Verfahren nach einem der Ansprüche 12 bis 15, dadurch gekennzeichnet, dass in einem ersten Verfahrensschritt während der Ueberführung des Metalls (13) in den gasförmigen Zustand nur das erste Gas in die Vakuumkammer (1) eingelasssen wird, um unmittelbar auf der Oberfläche des Werkstücks (2) einen Trennschichtbereich (B) zu bilden, der keine chemische Verbindung mit dem zweiten Gas enthält, und anschliessend in einem zweiten Verfahrensschritt das zweite Gas unter Verringerung des Zuflusses des ersten Gases eingeleitet wird.

17. Verfahren nach einem der Ansprüche 12 bis 16 zur Herstellung des beschichteten Werkstücks (2) nach Anspruch 3, dadurch gekennzeichnet, dass in einem ersten Verfahrensschritt während der Ueberführung des Metalls (13) in den gasförmigen Zustand nur das erste Gas in die Vakuumkammer (1) eingelassen wird, um unmittelbar auf dem Werkstück (2) einen Trennschichtbereich (B) zu bilden, der keine chemische Verbindung mit dem zweiten Gas enthält, und anschliessend in einem zweiten Verfahrensschritt zur Bildung des ersten Mischkristallbeschichtungs-Teilbereichs (C) das zweite Gas unter Verringerung des Zuflusses des ersten Gases eingeleitet wird und in einem dritten Verfahrensschritt der Zufluss des ersten und zweiten Gases annähernd konstant auf dem zuletzt eingestellten Wert des zweiten Verfahrensschritts zur Bildung des zweiten Mischkristallbeschichtungs-Teilbereichs (D) gehalten wird.

18. Verfahren nach einem der Ansprüche 12 bis 17, dadurch gekennzeichnet, dass als erstes Gas Stickstoff und als zweites Gas ein Kohlenstoff abgebendes Gas und als zu verdampfendes Metall Titan verwendet werden.

19. Verfahren nach den Ansprüchen 17 und 18, dadurch gekennzeichnet, dass der letzte, kleinste Zuflusswert des ersten Gases und der letzte, grösste Zuflusswert des zweiten Gases so eingestellt werden, dass ein TiC_{0,3}N_{0,7}-Mischkristall als zweiter Mischkristallbeschichtungs-Teilbereich (D) entsteht.

20. Vorrichtung zur Durchführung eines reaktiven PVD-Beschichtungsverfahrens nach einem der Ansprüche 12 bis 19 mit einer Vakuumkammer (1), einer Einlasseinheit (21, 22) für gasförmige Reaktionsmittel, einer bewegbaren Halterung (17) für die zu beschichtenden Werkstücke (2) und einer in der Vakuumkammer (1) angeordneten, mittels einer Bewegungseinrichtung (14) bewegbaren Dampfquelle (11).

21. Vorrichtung nach Anspruch 20, dadurch gekennzeichnet, dass die Halterung (17) drehbar ist.

## Claims

1. A coated workpiece (2) with a firmly adhering, tough solid-solution coating (C, D) which is applied by a reactive physical coating process and which comprises titanium nitride and titanium carbide whose concentration ratio relative to each other, at least in a predominant solid-solution coating sub-region (C), continuously increases and decreases with a periodic component of change (k) in the direction of the surface normal.

2. A coated workpiece (2) according to claim 1 characterised in that the solid-solution coating (C, D) is arranged on an interface layer region (B) which contains only titanium nitride or titanium carbide, that the pattern of concentration in respect of titanium nitride and titanium carbide respectively is constant between the interface region (B) and the solid-solution coating (C, D) and that the solid-solution coating (C, D) is preferably 1.2 to 2 times as thick as the interface region (B).

3. A coated workpiece (2) according to claim 2 characterised in that the solid-solution coating (C, D) comprises a first solid-solution coating sub-region (C), which is towards the workpiece (2), with a continuously changing concentration ratio, and a second thinner solid-solution coating sub-region (D), which is remote from the workpiece, with an at least approximately constant concentration ratio, wherein the concentration ratio of the first sub-region (C) continuously merges into that of the second sub-region (D) and the first sub-region (C) is 2 to 5 times as thick as the second (D).

4. A coated workpiece (2) according to one of claims 1 to 3 characterised in that superimposed on the periodic component of change (k) of the concentration ratio in the first solid-solution coating subrange (C, D) is a second component of change (m, n) which increases or decreases in the manner of a straight line in the direction of the surface normal.

5. A coated workpiece (2) according to one of claims 1 to 4 characterised in that the concentration ratio, periodically fluctuating in the direction of the surface normal, increases or decreases with preferably 1 to 5 fluctuations per approximately two micrometres of layer thickness.

6. A coated workpiece (2) according to one of claims 1 to 5 characterised in that superimposed on the periodic first component of change (k) of the concentration ratio is a periodic third nent of change (s) of the concentration ratio with a shorter spatial period and a lower fluctuation in concentration ratio at 5 to 100 fluctuations in respect of the third component of change (s) per fluctuation in respect of the first component of change (k).

7. A coated workpiece (2) according to one of claims 2 to 6 characterised in that the interface layer region (B) lies on a base layer (A) which is preferably 0.01 to 0.5 µm in thickness.

8. A coated workpiece (2) according to one of claims 1 to 7 characterised in that the interface layer region (B) comprises titanium nitride.

9. A coated workpiece (2) according to one of claims 1 to 8 characterised in that the base layer (A) comprises titanium.

10. A coated workpiece (2) according to one of claims 3 to 9 characterised in that the second sub-layer region (D) comprises a solid solution with approximately 30% titanium carbide and 70% titanium nitride.

11. A coated workpiece (2) according to one of claims 1 to 10 characterised in that it is in the form of a cutting or shaping tool.

12. A reactive PVD coating process for the production of the coated workpiece (2) according to one of claims 1 to 11 wherein a metal which is converted into the gaseous state by means of a vapour source (11) in a vacuum chamber (1) is deposited on a surface of a moved workpiece (2), with chemical reaction with a gaseous reactant introduced into the vacuum chamber (1), characterised in that as the reactants a first gas is introduced at a continuously reduced feed flow and a second gas is introduced at a continuously increased feed flow, for the formation of a first and a second compound respectively, and the workpiece (2) is relatively so moved in relation to the vapour source (11) that the spacing thereof and/or the orientation thereof with respect to the vapour source (11) periodically alters at such a speed that deposited on the workpiece (1) is a solid-solution coating with said compounds whose concentration ratio relative to each other is made up only in the direction of the surface normal from superimposition of the periodic changes in concentration corrresponding to the changes in spacing and the change in concentration corresponding to the change in feed flow.

13. A process according to claim 12 wherein the metal (13) is vaporised from a vapour source (11) by means of an arc vaporisation operation, in particular a low-voltage arc vaporisation operation.

14. A process according to claim 12 or claim 13 characterised in that the vapour source (11) is periodically moved along the workpiece surface to be coated in such a way that the concentration ratio of said compounds of the solid-solution coating sub-region (C) which is formed on the surface changes along the direction of movement.

15. A process according to claims 12 and 14 or 13 and 14 characterised in that the vapour source (11) is moved at a lower speed than the workpiece (2).

16. A process according to one of claims 12 to 15 characterised in that in a first process step during transformation of the metal (13) into the gaseous state only the first gas is let into the vacuum chamber (1) in order to form directly on the surface of the workpiece (2) an interface layer region (B) which does not contain any chemical compound with the second gas, and then in a second process step the second gas is introduced with a reduction in the feed flow of the first gas.

17. A process according to one of claims 12 to 16 for the production of the coated workpiece (2) according to claim 3 characterised in that in a first process step during transformation of the metal (13) into the gaseous state only the first gas is let into the vacuum chamber (1) in order to form directly on the workpiece (2) an interface layer region (B) which does not contain any chemical compound with the second gas, and then in a second process step to form the first solid-solution coating sub-region (C) the second gas is introduced with a reduction in the feed flow of the first gas and in a third process step the feed flow of the first and second gases is kept approximately constantly at the last-set value in the second process step for forming the second solid-solution coating sub-region (D).

18. A process according to one of claims 12 to 17 characterised in that the first gas used is nitrogen and the second gas used is a gas which gives off carbon and the metal to be vaporised is titanium.

19. A process according to claims 17 and 18 characterised in that the last lowest feed flow value for the first gas and the last greatest feed flow value for the second gas are so set that a TiC_{0.3}N_{0.7}-solid solution is produced as the second solid-solution coating sub-region(D).

20. Apparatus for carrying out a reactive PVD coating process according to one of claims 12 to 19 having a vacuum chamber (1), an inlet unit (21, 22) for gaseous reactants, a movable holder (17) for the workpieces (2) to be coated, and a vapour source (11) which is arranged in the vacuum chamber (1) and which is movable by means of a motion device (14).

21. Apparatus according to claim 20 characterised in that the holder (17) is rotatable.

## Revendications

1. Pièce (2) pourvue d'un revêtement, comportant une couche cristalline mixte (C, D) résistante et présentant une bonne adhérence, déposée suivant un procédé de revêtement physique réactif et formée de nitrure de titane et de carbure de titane, dont le rapport de concentration l'un par rapport à l'autre augmente et diminue de façon continue avec une composante (k) de variation périodique en direction de la normale à la surface, au moins dans une zone partielle (C) prépondérante de la couche cristalline mixte.

2. Pièce (2) pourvue d'un revêtement selon la revendication 1, caractérisée en ce que la couche cristalline mixte (C, D) est disposée sur une zone de couche de séparation (B) qui contient uniquement du nitrure de titane ou du carbure de titane, en ce que l'évolution de la concentration concernant le nitrure de titane ou le carbure de titane entre la zone de couche de séparation (B) et la couche cristalline mixte (C, D) est continue, et en ce que la couche cristalline mixte (C, D) est de préférence 1,2 à 2 fois plus épaisse que la zone de couche de séparation (B)

3. Pièce (2) pourvue d'un revêtement selon la revendication 2, caractérisée en ce que la couche cristalline mixte (C, D) est constituée d'une première zone partielle (C) de la couche cristalline mixte, qui est appliquée directement sur la pièce (2), dont le rapport de concentration varie de façon continue, et d'une deuxième zone partielle (D) plus mince de la couche cristalline mixte, qui est éloignée de la pièce, dont le rapport de concentration est au moins approximativement constant, le rapport de concentration de la première zone partielle (C) s'intégrant de façon continue dans celui de la deuxième zone partielle (D), et la première zone partielle (C) étant 2 à 5 fois plus épaisse que la deuxième (D).

4. Pièce (2) pourvue d'un revêtement selon l'une quelconque des revendications 1 à 3, caractérisée en ce que, à la composante (k) de variation périodique du rapport de concentration dans la première zone partielle de la couche cristalline mixte (C, D), il est superposé une deuxième composante de variation (m, n), qui augmente ou diminue en direction de la normale à la surface suivant une droite.

5. Pièce (2) pourvue d'un revêtement selon l'une quelconque des revendications 1 à 4, caractérisée en ce que le rapport de concentration augmente ou diminue par variations périodiques en direction de la normale à la surface, de préférence à raison de 1 à 5 variations par deux micromètres environ d'épaisseur de couche.

6. Pièce (2) pourvue d'un revêtement selon l'une quelconque des revendications 1 à 5, caractérisée en ce que, à la première composante (k) de variation périodique du rapport de concentration, il est superposé une troisième composante (s) de variation périodique du rapport de concentration, avec une plus faible période dans l'espace et une plus faible variation de rapport de concentration, la troisième composante (s) de variation présentant 5 à 100 variations par variation de la première composante (k) de variation

7. Pièce (2) pourvue d'un revêtement selon l'une quelconque des revendications 2 à 6, caractérisée en ce que la zone de la couche de séparation (B) est située sur une sous-couche (A) qui a de préférence une épaisseur de 0,01 à 0,5 µm.

8. Pièce (2) pourvue d'un revêtement selon l'une quelconque des revendications 1 à 7, caractérisée en ce que la zone de la couche de séparation (B) est en nitrure de titane.

9. Pièce (2) pourvue d'un revêtement selon l'une quelconque des revendications 1 à 8, caractérisée en ce que la sous-couche (A) est en titane.

10. Pièce (2) pourvue d'un revêtement selon l'une quelconque des revendications 3 à 9, caractérisée en ce que la deuxième zone partielle (D) est en cristal mixte contenant approximativement 30 % de carbure de titane et 70 % de nitrure de titane.

11. Pièce (2) pourvue d'un revêtement selon l'une quelconque des revendications 1 à 10, caractérisée en ce qu'elle est réalisée sous la forme d'un outil de coupe ou de formage.

12. Procédé de revêtement PVD réactif destiné à la fabrication de la pièce (2) pourvue d'un revêtement selon l'une quelconque des revendications 1 à il, selon lequel un métal transformé à l'état gazeux dans une chambre à vide (1) au moyen d'une source de vapeur (11) est déposé sur la surface d'une pièce (2) en mouvement par réaction chimique avec un réactif gazeux introduit dans la chambre à vide (1), caractérisé en ce que, en tant que réactif destiné à constituer une première et une deuxième liaison, il est introduit un premier gaz dont le débit est constamment réduit et un deuxième gaz dont le débit est constamment augmenté, et en ce que la pièce (2) est déplacée par rapport à la source de vapeur (il) de telle sorte que sa distance et/ou son orientation par rapport à la source de vapeur (11) se modifie périodiquement à une vitesse telle qu'une couche cristalline mixte contenant les composants mentionnés soit déposée sur la pièce (2), le rapport de concentration des composants l'un par rapport à l'autre en direction de la normale à la surface résultant uniquement d'une superposition des variations de concentration correspondant aux variations périodiques de distance et de la variation de concentration correspondant à la variation du débit.

13. Procédé selon la revendication 12, selon lequel le métal (13) est vaporisé à partir d'une source de vapeur (11) au moyen d'une vaporisation à l'arc, notamment d'une vaporisation à l'arc basse tension.

14. Procédé selon la revendication 12 ou 13, caractérisé en ce que la source de vapeur (11) est périodiquement déplacée le long de la surface de la pièce à revêtir de telle sorte que le rapport de concentration des composés mentionnés de la zone partielle (C) de la couche cristalline mixte se formant à la surface, varie le long de la direction de déplacement.

15. Procédé selon les revendications 12 et 14 ou 13 et 14, caractérisé en ce que la source de vapeur (11) est déplacée à une plus faible vitesse que la pièce (2).

16. Procédé selon l'une quelconque des revendications 12 à 15, caractérisé en ce que dans une première phase de procédé, pendant la transformation du métal (13) à l'état gazeux, seul le premier gaz est admis dans la chambre à vide (1) afin de former directement sur la surface de la pièce (2) une zone de couche de séparation (B) qui ne contient aucun composé chimique du deuxième gaz, et qu'ensuite, dans une deuxième phase de procédé, le deuxième gaz est admis en réduisant le débit du premier gaz.

17. Procédé selon l'une quelconque des revendications 12 à 16 destiné à la fabrication de la pièce (2) pourvue d'un revêtement selon la revendication 3, caractérisé en ce que dans une première phase de procédé, pendant la transformation du métal (13) à l'état gazeux, seul le premier gaz est admis dans la chambre à vide (1) afin de former directement sur la pièce (2) une zone de couche de séparation (B) qui ne contient aucun composé chimique du deuxième gaz, et qu'ensuite, dans une deuxième phase de procédé, le deuxième gaz est admis en réduisant le débit du premier gaz pour constituer la première zone partielle (C) da la couche cristalline mixte, et en ce que, dans une troisième phase de procédé, les débits du premier et du deuxième gaz sont maintenus approximativement constants à la valeur réglée en dernier lieu au cours de la deuxième phase de procédé, pour constituer la deuxième zone partielle (D) de la couche cristalline mixte.

18. Procédé selon l'une quelconque des revendications 12 à 17, caractérisé en ce qu'il est utilisé de l'azote en tant que premier gaz, un gaz libérant du carbone en tant que deuxième gaz, et du titane en tant que métal à vaporiser.

19. Procédé selon les revendications 17 et 18, caractérisé en ce que la dernière valeur de débit, la plus faible, du premier gaz et la dernière valeur de débit, la plus forte, du deuxième gaz sont réglées de telle sorte qu'il est obtenu un cristal mixte TiC_{0,3}N_{0,7} en tant que deuxième zone partielle (D) de la couche cristalline mixte.

20. Dispositif destiné à la mise en oeuvre d'un procédé de revêtement PVD réactif selon l'une quelconque des revendications 12 à 19, comportant une chambre à vide (1), une unité d'admission (21, 22) pour des réactifs gazeux, une attache mobile (17) pour les pièces (2) à revêtir et une source de vapeur (11) disposée dans la chambre à vide (1), qui peut être déplacée au moyen d'un dispositif de déplacement (14).

21. Dispositif selon la revendication 20, caractérisé en ce que l'attache (17) peut être mise en rotation.
